# EUROPEAN PATENT APPLICATION

(11) **EP 4 187 525 A2**
(43) Date of publication of application: **31.05.2023**
(21) Application number: 22206293.7
(22) Date of filing: 09.11.2022
(51) Int. Cl.: G09G 3/00

(54) **MANUFACTURING METHOD OF ELECTRONIC DEVICE**

(30) Priority: 26.11.2021 US 202163283297 P; 01.08.2022 CN 202210918353
(71) Applicant: InnoLux Corporation, Jhunan Town Miao li 35053 (TW)
(72) Inventor: TSAI, Tsung-Han, 35053 Jhunan Town, Miaoli County (TW); LIUS, Chandra, 35053 Jhunan Town, Miaoli County (TW); CHI, Jen-Hai, 35053 Jhunan Town, Miaoli County (TW)
(74) Representative: Becker, Eberhard

(57) **Abstract**

A manufacturing method of an electronic device including following steps is provided. A tuning element substrate having a circuit layer disposed on a substrate and a plurality of tuning elements disposed on the circuit layer is provided. A reverse bias voltage or a forward bias voltage is applied to the tuning elements, so as to test a variation of an electrical property or a variation of an optical property of each of the tuning elements. The variation of the electrical property or the variation of the optical property of each of the tuning elements is analyzed. According to the manufacturing method, a reliable testing method of an electronic device may be provided.

## Description

### BACKGROUND

### Technical Field

The disclosure relates to a manufacturing method of an electronic device.

### Description of Related Art

To ensure normal operation of electronic elements in an electronic device, the electronic elements may be tested in the process of forming the electronic device. Therefore, a testing plan of the electronic elements plays an important role in the process of forming the electronic device.

### SUMMARY

The disclosure provides a manufacturing method of an electronic device, which may provide a reliable testing method of an electronic device.

In an embodiment of the disclosure, a manufacturing method of an electronic device includes following steps. A tuning element substrate having a circuit layer disposed on a substrate and a plurality of tuning elements disposed on the circuit layer is provided. A first reverse bias voltage is applied to the tuning elements, so as to test a first variation of an electrical property of each of the tuning elements. The first variation of the electrical property of each of the tuning elements is analyzed.

In an embodiment of the disclosure, a manufacturing method of an electronic device includes following steps. A tuning element substrate having a circuit layer disposed on a substrate and a plurality of tuning elements disposed on the circuit layer is provided. A first forward bias voltage is applied to the tuning elements, so as to test a first variation of an optical property of each of the tuning elements. The first variation of the optical property of each of the tuning elements is analyzed.

In order for the features and advantages of the disclosure to be more comprehensible, the following specific embodiments are described in detail in conjunction with the drawings.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles provided in the disclosure.
FIG. 1A to FIG. 1H are schematic cross-sectional views of a manufacturing process of a portion of an electronic device according to an embodiment of the disclosure.
FIG. 2A is a circuit diagram of an electronic device according to an embodiment of the disclosure.
FIG. 2B is a circuit diagram of an electronic device according to another embodiment of the disclosure.
FIG. 3 is a schematic top view of FIG. IE according to a first embodiment of the disclosure.
FIG. 4 is a schematic top view of FIG. IE according to a second embodiment of the disclosure.
FIG. 5 is a schematic top view of FIG. IE according to a third embodiment of the disclosure.
FIG. 6 is a schematic top view of FIG. IE according to a fourth embodiment of the disclosure.
FIG. 7 is a schematic top view of FIG. IE according to a fifth embodiment of the disclosure.
FIG. 8 is a schematic top view of FIG. IE according to a sixth embodiment of the disclosure.
FIG. 9 is a schematic top view of FIG. IE according to a seventh embodiment of the disclosure.

### DESCRIPTION OF THE EMBODIMENTS

The disclosure may be understood by referring to the following detailed description with reference to the accompanying drawings. It is noted that for comprehension of the reader and simplicity of the drawings, in the drawings provided in the disclosure, only a part of the electronic device is shown, and certain devices in the drawings are not necessarily drawn to actual scale. Moreover, the quantity and the size of each device in the drawings are only schematic and exemplary and are not intended to limit the scope of protection provided in the disclosure.

Certain terminologies will be used to refer to specific devices throughout the specification and the appended claims of the disclosure. People skilled in the art should understand that manufacturers of electronic devices may refer to same elements under different names. The disclosure does not intend to distinguish devices with the same functions but different names. In the following specification and claims, the terminologies " including," "containing," "having," etc. are open-ended terminologies, so they should be interpreted to mean "including but not limited to ...". Therefore, when the terms " including," "containing," and/or "having" are used in the description of the disclosure, the terminologies designate the presence of a corresponding feature, region, step, operation, and/or element, but do not exclude the presence of one or more corresponding features, regions, steps, operations, and/or elements.

Directional terminologies mentioned herein, such as "top", "bottom", "front", "back", "left", "right", and so forth, refer to directions in the accompanying reference drawings. Accordingly, the directional terminologies provided herein serve to describe rather than limiting the disclosure. In the accompanying drawings, each figure illustrates methods applied in particular embodiments and general features of structures and/or materials in the embodiments. However, these figures should not be construed or defined as the scope covered by the particular embodiments. For instance, relative dimensions, thicknesses, and positions of various layers, regions, and/or structures may be reduced or enlarged for clarity.

When a corresponding element (such as a film layer or a region) is referred to as being "on another element ", the element may be directly on the other element or there may be another element between the two. On the other hand, when an element is referred to as being "directly on another element ", there is no element between the two. Also, when an element is referred to as being "on another element ", the two have a top-down relationship in the top view direction, and the element may be above or below the other element, and the top-down relationship depends on the orientation of the device.

The terminologies "about", "substantially" or "approximately" are generally interpreted as being within 10% of a given value or range, or interpreted as being within 5%, 3%, 2%, 1%, or 0.5% of a given value or range.

The terminologies such as "first", "second", etc. may be used to describe elements, but the elements should not be limited by these terminologies. The terminologies are only intended to distinguish an element from another element in the specification. It is possible that the claims do not use the same terminologies and replace the terminologies with "first", "second", etc. according to the sequence provided in the claims. Accordingly, in the specification, a first element may be a second element in the claims.

It should be understood that the following embodiments may replace, reorganize, and mix the features in several different embodiments to complete other embodiments without departing from the spirit of the disclosure. As long as the features of the embodiments do not violate the spirit of the disclosure or conflict each other, they may be mixed and matched as desired.

An electrical connection or coupling relationship described in this disclosure may refer to a direct connection or an indirect connection. In the case of the direct connection, end points of the elements on two circuits are directly connected or connected to each other by a conductor segment, and in the case of the indirect connection, there are switches, diodes, capacitors, inductors, resistors, other appropriate elements, or a combination of the above elements between the end points of the elements on the two circuits, which should not be construed as a limitation in the disclosure.

In this disclosure, measurement of thickness, length, and width may be done by applying an optical microscope, and the thickness or the width may be obtained by measuring a cross-sectional image in an electron microscope, which should not be construed as a limitation in the disclosure. In addition, certain errors between any two values or directions for comparison may be acceptable. Moreover, the descriptions "a given range is from a first value to a second value" and "a given range falls within a range from the first value to the second value" indicate that the given range includes the first value, the second value, and the intervening values. If a first direction is perpendicular to a second direction, an angle difference between the first direction and the second direction may be between 80 degrees and 100 degrees; if the first direction is parallel to the second direction, an angle difference between the first direction and the second direction may be between 0 degrees and 10 degrees.

The electronic device provided in the disclosure may include a display device, an antenna device, a sensing device, a light emitting device, or a tilted device, but is not limited thereto. The electronic device may include a bendable or flexible electronic device. The electronic device may include electronic elements. The electronic device may include liquid crystal layers or light emitting diodes (LED), and the electronic elements can include passive elements and active elements, such as capacitors, resistors, inductors, variable capacitors, filters, diodes, transistors, sensors, microelectromechanical system (MEMS) elements, liquid crystal chips, etc., but not limited thereto. The diode may include LED or photodiodes. The diode may include P-N junction diode, PIN diode, or constant current diodes. The LEDs may include, for example, organic light emitting diodes (OLED), mini LED, micro LED, quantum dot LED, fluorescence, phosphor, or other suitable materials, or a combination of the above, but not limited thereto. The sensor may, for example, include capacitive sensors, optical sensors, electromagnetic sensors, fingerprint sensors (FPS), touch sensors, antenna, pen sensors, or the like, but not limited thereto. Hereinafter, the display device will be used as an electronic device to illustrate the content of the disclosure, but the disclosure is not limited thereto.

Reference will now be made in detail to the exemplary embodiments of the disclosure, and examples of the exemplary embodiments are illustrated in the accompanying drawings. Whenever possible, the same reference numbers are used in the drawings and descriptions to indicate the same or similar parts.

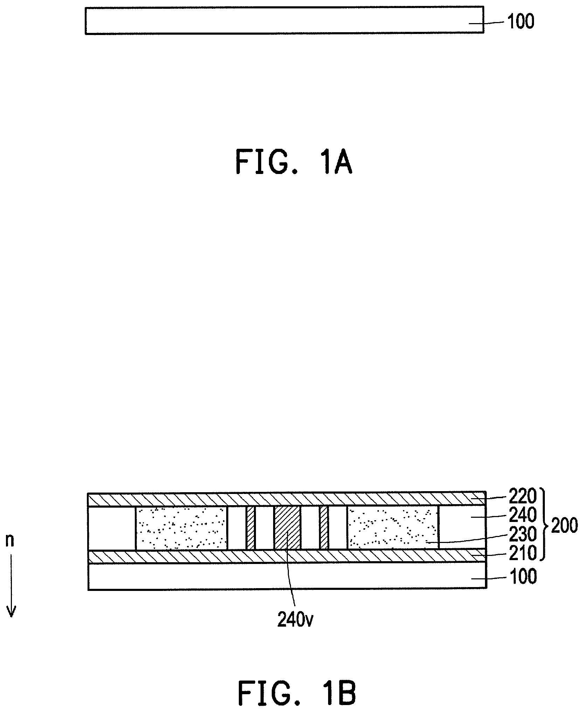

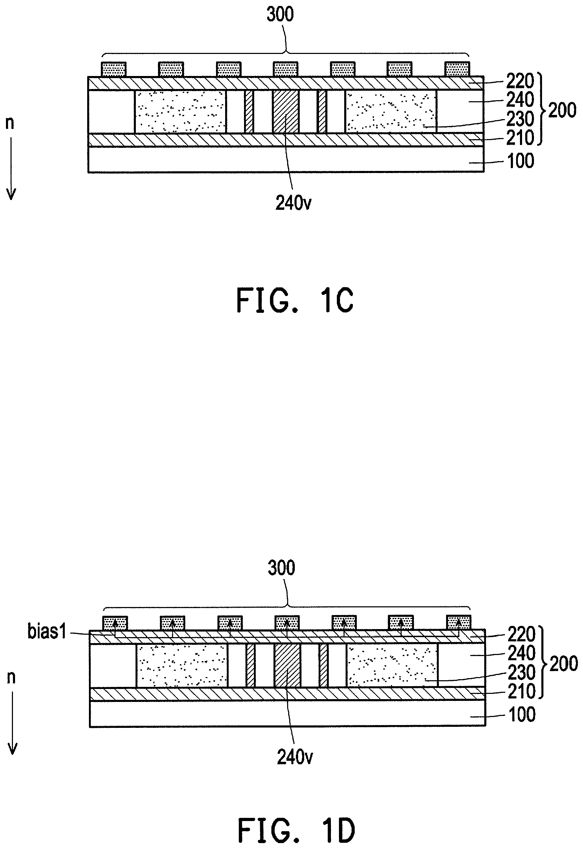

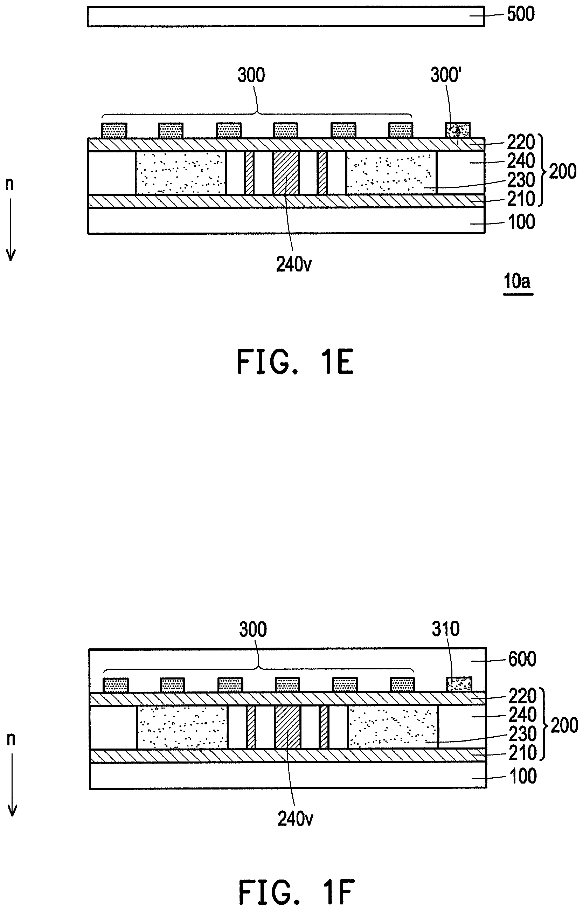

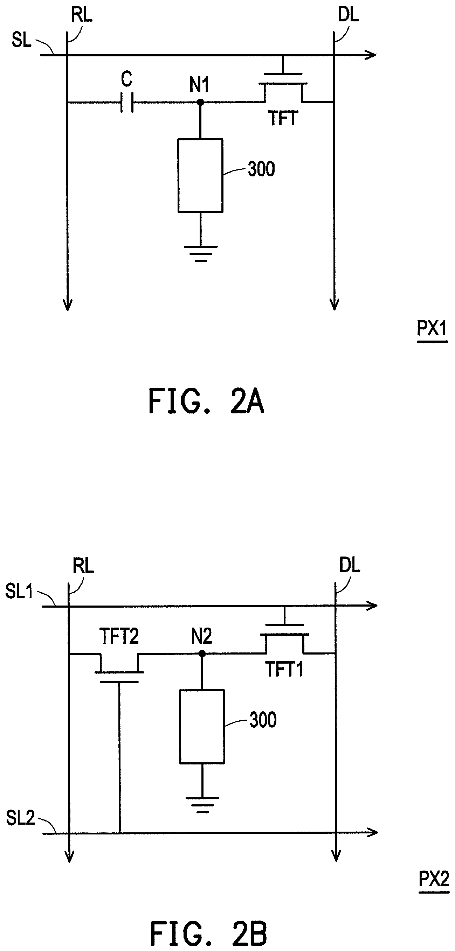

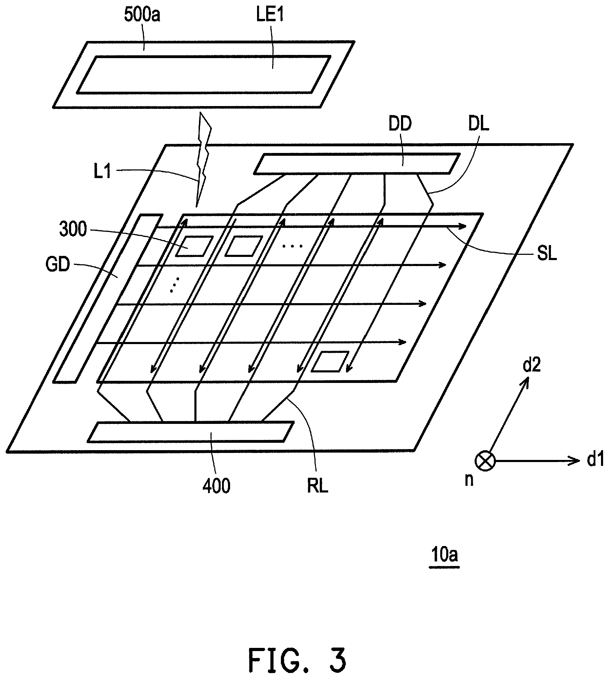

FIG. 1A to FIG. 1H are schematic cross-sectional views of a manufacturing process of a portion of an electronic device according to an embodiment of the disclosure. FIG. 2A is a circuit diagram of an electronic device according to an embodiment of the disclosure. FIG. 2B is a circuit diagram of an electronic device according to another embodiment of the disclosure. FIG. 3 is a schematic top view of FIG. IE according to a first embodiment of the disclosure. The manufacturing process depicted in FIG. 1A to FIG. 1H is merely exemplary and should not be construed as a limitation to the manufacturing steps of the electronic device.

A tuning element substrate may have a circuit layer 200 and a plurality of tuning elements 300. The circuit layer 200 may be disposed on a substrate 100, and the plurality of tuning elements 300 may be disposed on the circuit layer 200. With reference to FIG. 1A, the substrate 100 is provided. A material of the substrate 100 may include, for instance, glass, plastic, or a combination thereof. For instance, the material of the substrate 100 may include quartz, sapphire, silicon (Si), germanium (Ge), silicon carbide (SiC), gallium nitride (GaN), silicon germanium (SiGe), polymethyl methacrylate (PMMA), polycarbonate (PC), polyimide (PI), polyethylene terephthalate (PET), other appropriate materials, or combinations of the above materials, which should not be construed as a limitation in the disclosure. In some embodiments, the substrate 100 may include a transparent substrate, and a reflective metal layer may be disposed on a surface of the substrate 100, which should however not be construed as a limitation in the disclosure.

Next, with reference to FIG. 1B, the circuit layer 200 is disposed on the substrate 100. In this embodiment, the circuit layer 200 includes a circuit layer 210, a circuit layer 220, a driver element 230, and a molding layer 240. The circuit layer 210 and the circuit layer 220 may, for instance, include signal lines having various functions. For instance, the circuit layer 210 and the circuit layer 220 may include a combination of scan lines, data lines, read lines, operating signal lines, common lines, and power lines, which should however not be construed as a limitation in the disclosure. The driver element 230 is disposed between and electrically connected to the circuit layer 210 and the circuit layer 220 in a top-view direction n of the substrate 100, for instance. In some embodiments, the driver element 230 includes a driver chip, an active element, a passive element, or other appropriate electronic elements, which should however not be construed as a limitation in the disclosure. For instance, the driver element 230 may include a gate driver unit, a data driver unit, a power source driver unit, and so on, which should however not be construed as a limitation in the disclosure. The molding layer 240 is, for instance, disposed between the circuit layer 210 and the circuit layer 220 and adjacent to or surrounding the driver element 230. For instance, a top surface and a bottom surface of the molding layer 240 may be coplanar with a top surface and a bottom surface of the driver element 230, respectively, so that the molding layer 240 may laterally cover the driver element 230, which should however not be construed as a limitation in the disclosure. The molding layer 240 may be configured to fix or protect the driver element 230, for instance. In some embodiments, a material of the molding layer 240 may include epoxy resin, silicone, other suitable materials, or a combination thereof. In addition, in this embodiment, the molding layer 240 includes a plurality of vias 240v, and the circuit layer 210 and the circuit layer 220 may be electrically connected to each other through the vias 240v. For instance, the vias 240v may be filled with a conductive material, and the circuit layer 210 and the circuit layer 220 may be electrically connected through the conductive material.

With reference to FIG. 1C, the plurality of tuning elements 300 are disposed on the circuit layer 200. The tuning elements 300 may be, for instance, applicable in the communication field, the radar/lidar field, in the field of reconfigurable intelligent surface (RIS), or other appropriate technical fields, which should however not be construed as a limitation in the disclosure. In some embodiments, the tuning element 300s may include variable capacitors, variable resistors, varactor diodes, phase shifters, amplifiers, antennas, biometric sensors, graphene-based sensors, other suitable tuning elements, or combinations thereof. The tuning elements 300 are, for instance, capable of increasing an operable bandwidth. In some embodiments, the tuning elements 300 may adjust a frequency within a range from about 3MHz to 300THz, which should however not be construed as a limitation in the disclosure.

With reference to FIG. ID, a bias voltage bias1 is applied to the tuning elements 300, so as to test a variation of an electrical property or a variation of an optical property of each of the tuning elements 300 and analyze the variations of the electrical properties or the variations of the optical properties of the tuning elements 300.

In some embodiments, a reverse bias voltage is applied to the tuning elements 300, so as to test the variation of the electrical property of each of the tuning elements 300. In detail, the tuning elements 300 may be operated in a reverse bias mode as exemplarily shown by the circuit diagram of the electronic device respectively in FIG. 2A and FIG. 2B, which should however not be construed as a limitation in the disclosure.

In the embodiment shown in FIG. 2A, a pixel circuit PX1 includes an active element TFT, a scan line SL, a data line DL, a tuning element 300, a read line RL, and a capacitor C. A control terminal of the active element TFT is, for instance, coupled to the scan line SL to receive a scan signal from the scan line SL. A first terminal of the active element TFT is, for instance, coupled to the data line DL to receive a data signal from the data line DL. A second terminal of the active element TFT and a first terminal of the tuning element 300 are, for instance, coupled to a node N1, so that the tuning element 300 is operated according to a voltage level at the first terminal of the tuning element 300. A second terminal of the tuning element 300 may be grounded, for instance, which should however not be construed as a limitation in the disclosure. In other embodiments, a reverse operating voltage may be applied to the second terminal of the tuning element 300. The capacitor C is coupled between the node N1 and the read line RL, so as to transmit an electrical signal from the tuning element 300 to the read line RL through capacitive coupling.

In the embodiment shown in FIG. 2B, a pixel circuit PX2 includes an active element TFT1, an active element TFT2, a scan line SL1, a scan line SL2, a data line DL, a tuning element 300, and a read line RL. A control terminal of the active element TFT1 is, for instance, coupled to the scan line SL1 to receive a scan signal from the scan line SL1. A first terminal of the active element TFT1 is, for instance, coupled to the data line DL to receive a data signal from the data line DL. A second terminal of the active element TFT1 and a first terminal of the tuning element 300 are, for instance, coupled to a node N2, so that the tuning element 300 is operated according to a voltage level at the first terminal of the tuning element 300. A second terminal of the tuning element 300 may be grounded, for instance, which should however not be construed as a limitation in the disclosure. In other embodiments, a reverse operating voltage may be applied to the second terminal of the tuning element 300. A control terminal of the active element TFT2 is, for instance, coupled to the scan line SL2 to receive a scan signal from the scan line SL2. A first terminal of the active element TFT2 is, for instance, coupled to the node N2, and a second terminal of the active element TFT2 is, for instance, coupled to the read line RL; as such, when the active element TFT2 is turned on, an electrical signal coming from the tuning element 300 may be transmitted to the read line RL.

The pixel circuit PX1 shown in FIG. 2A is taken as an example. Here, the scan signal and the data signal respectively corresponding to the scan line SL and the data line DL may be provided, so that the tuning element 300 may be operated in a reverse bias mode, and the tuning element 300 may transmit an electrical signal to the read line RL through the capacitor C in a capacitive coupling manner, which should however not be construed as a limitation in the disclosure.

In other embodiments, a forward bias voltage may be applied to a plurality of tuning elements 300, so that a variation of an optical property of each of the tuning elements 300 may be tested. For instance, the tuning elements 300 may perform a function of emitting or reflecting a light beam when the tuning elements 300 are operated in a forward bias mode, and the light beam emitted or reflected by the tuning elements 300 may be received by a testing device.

With reference to FIG. IE, the variations of the electrical properties or the variations of the optical properties of the tuning elements 300 are analyzed. In detail, when a reverse bias voltage is applied to the tuning elements 300, the testing device 500 may be selectively applied to provide a signal (which may be an optical signal or an electrical signal) to the tuning elements 300, and the variations of the electrical properties of the tuning elements 300 may be analyzed by a processing chip 400.

FIG. 3 illustrates an analysis performed on the variations of the electrical properties of the tuning elements 300 of an electronic device 10a according to an embodiment of the disclosure. The electronic device 10a includes scan lines SL, data lines DL, a gate driver GD, a data driver DD, the tuning elements 300, read lines RL, and the processing chip 400. In this embodiment, a light emitting element LEI in the testing device 500a serves to provide an optical signal (a light beam LI) to the tuning elements 300. In some embodiments, a wavelength of the light beam emitted by the light emitting element LEI in the testing device 500a is 150 nm-1500 nm, which should however not be construed as a limitation in the disclosure. The scan lines SL extend toward a first direction d1, for instance, and the data lines DL extend toward a second direction d2, for instance. Here, the first direction d1 and the second direction d2 are different, and the first direction d1 and the second direction d2 may be perpendicular to each other, for instance, which should however not be construed as a limitation in the disclosure. The gate driver GD is, for instance, connected to the scan lines SL and driven by an operating signal line (not shown), and the gate driver GD may, through the scan lines SL, transmit the corresponding scan signals to the active element (e.g., the active element TFT, the active element TFT1, or the active element TFT2 described above) coupled to the scan lines SL, so that the active element is turned on. The data driver DD is, for instance, connected to the data lines DL and may, through the data lines DL, transmit the corresponding data signals to the active element (e.g., the active element TFT, the active element TFT1, or the active element TFT2 described above) coupled to the data lines SL. The tuning elements 300 are, for instance, coupled to the aforementioned active element and the read lines RL. The tuning elements 300 provided in this embodiment may be operated in the reverse bias mode through the corresponding scan signals and data signals and may transmit the resultant electrical signals to the read lines RL. For instance, the read lines RL extend toward the second direction d2 and are coupled to the processing chip 400 and the tuning elements 300 disposed on the substrate 100, so as to transmit the electrical signals from the tuning elements 300 to the processing chip 400. The processing chip 400 may, for instance, read the electrical signals coming from the tuning elements 300 through the read lines RL and analyze the tuning elements 300 according to the electrical signals. In other embodiments, note that the electronic device 10a may not include the processing chip 400, while an external processing chip (not shown) may be applied to analyze the tuning elements 300.

In the embodiment shown in FIG. 3, through irradiating the tuning elements 300 with the light beam L1 by the light emitting element LEI in the testing device 500a, variations of electrical properties of the electrical signals of the tuning elements 300 may be generated, the electrical signals whose electrical properties are varied may be read by the processing chip 400 coupled to the read lines RL, and whether the tuning elements 300 are defective may analyzed according to the electrical signals. In some embodiments, after the variations of the electrical properties of the tuning elements 300 are analyzed, and if it is detected that one or more of the tuning elements 300 are defective (e.g., a tuning element 300' shown in FIG. IE), the defective one or more of the tuning elements 300 (e.g., the tuning element 300') are repaired. A method of repairing the defective one or more of the tuning elements 300 (e.g., the tuning element 300') may include, for instance, removing the tuning element 300' and subsequently placing a new tuning element 310 (e.g., the tuning element 310 shown in FIG. 1F); alternatively, for instance, the new tuning element 310 may be disposed in a spare region adjacent to the defective one or more of the tuning elements 300 (e.g., the tuning element 300'), which should however not be construed as a limitation in the disclosure. It is worth noting that the defect of the tuning element 300' may be, for instance, a defect of the tuning element 300' itself or a defect of poor electrical connection between the tuning elements 300 and the pixel circuit (e.g., the pixel circuit PX1 or the pixel circuit PX2), which should however not be construed as a limitation in the disclosure.

So far, the manufacturing process of the electronic device 10a is completed. It is worth noting that although the manufacturing process of the electronic device 10a provided in this embodiment is described by taking the above process as an example, the manufacturing process of the electronic device 10a provided in the disclosure is not limited to what is described above; some steps in the above manufacturing process may be deleted as required, or additional steps may be added to the manufacturing process. In addition, the order of the above steps may be adjusted according to actual demands.

In some embodiments, the manufacturing process of the electronic device may further include following steps, which should however not be construed as a limitation in the disclosure.

With reference to FIG. IF, in some embodiments, a package layer 600 may also be placed on the tuning elements 300. The package layer 600 may be, for instance, formed by a compression molding process, a coating process, or any other appropriate process, which should not be construed as a limitation in the disclosure. In some embodiments, the package layer 600 is disposed on the circuit layer 220 and covers the tuning elements 300. A material of the package layer 600 may include, for instance, an organic material or any other appropriate material, which should not be construed as a limitation in the disclosure. In some embodiments, the material of the package layer 600 may be epoxy resin. In some embodiments, the package layer 600 may be formed by stacking a plurality of layers, where the thicknesses of the layers closer to the tuning elements 300 are greater than the thicknesses of the layers farther from the tuning elements 300, which should however not be construed as a limitation in the disclosure. In some embodiments, the package layer 600 may not include metal, which should not be construed as a limitation in the disclosure. In some embodiments, a heat transfer efficiency of the package layer 600 is greater than that of the molding layer 240, which should however not be construed as a limitation in the disclosure.

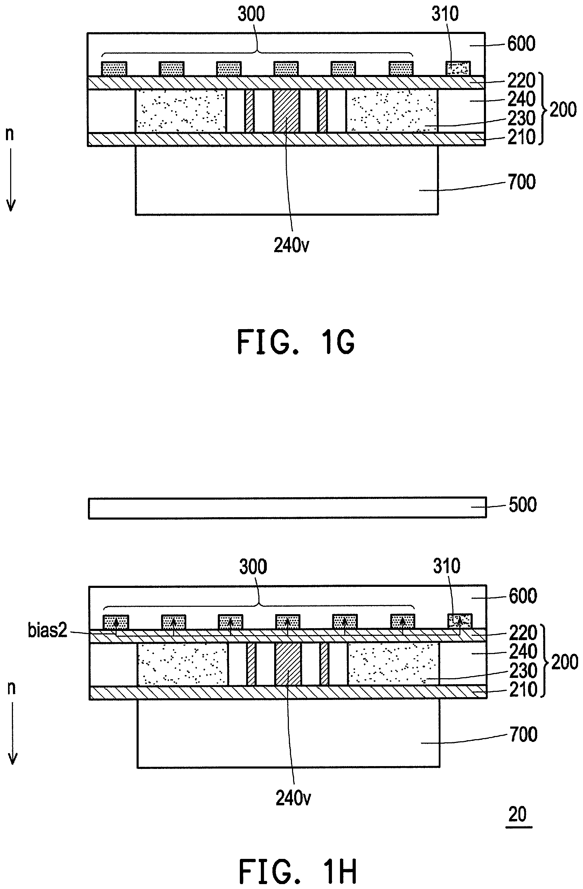

With reference to FIG. 1G, in some embodiments, the manufacturing process may include a step of providing a processing chip 700. The processing chip 700 is, for instance, disposed on a surface of the circuit layer 210 away from the tuning elements 300. For instance, the substrate 100 may be removed to expose the surface of the circuit layer 210 away from the tuning elements 300, and then the processing chip 700 is disposed on such a surface of the circuit layer 210, so that the processing chip 700 is electrically connected to the tuning elements 300, which should however not be construed as a limitation in the disclosure. In other embodiments, a plurality of vias may be formed in the substrate 100, and the processing chip 700 is disposed on the surface of the substrate 100 away from the tuning elements 300, where the processing chip 700 is electrically connected to the circuit layer 210 and the tuning elements 300 through the vias. In some embodiments, the processing chip 700 may include a power management integrated circuit (PMIC), a timing controller (T-Con), a communication chip, a Wi-fi antenna patch, a Bluetooth chip, a memory chip, or a combination thereof, which should not be construed as a limitation in the disclosure.

With reference to FIG. 1H, in some embodiments, the manufacturing process further includes a step of applying a bias voltage bias2 to the tuning elements 300 again, so that the variation of the electrical property or the variation of the optical property of each of the tuning elements 300 may be tested again. In addition, when the bias voltage bias2 is again applied to the tuning elements 300, the testing device 500 or another testing device may be optionally applied to provide a signal (which may be an optical signal or an electrical signal) to the tuning elements 300 again, and the variations of the electrical properties of the tuning elements 300 may be again analyzed at least by the processing chip 700.

In some embodiments, the reverse bias voltage is again applied to the tuning elements 300, so that the variation of the electrical property of each of the tuning elements 300 may be respectively tested again. Particularly, the tuning elements 300 may be operated in the reverse bias mode again, as exemplarily shown by the circuit diagram of the electronic device respectively in FIG. 2A and FIG. 2B, and thus the relevant description is not repeated hereinafter.

In some embodiments, a forward bias voltage may be again applied to the tuning elements 300, so that the variation of the optical property of each of the tuning elements 300 may be individually tested again.

In this embodiment, the processing chip 700 is configured to receive the variation of the electrical property or the variation of the optical property of each of the tuning elements 300 tested again, and the processing chip 700 converts the variation of the electrical property or the variation of the optical property of the individual tuning element 300 to electrical data (e.g., variability of the tuning element 300) and stores the electrical data. In some embodiments, the stored electrical data may be subsequently compensated, and the compensated signal may be transmitted to the gate driver GD and/or the data driver DD, which should however not be construed as a limitation in the disclosure.

In addition, after the analysis on the variation of the electrical property of the tuning elements is performed as shown in FIG. IE, and after one or more tuning elements 300 is found to be defective, the defective one or more tuning elements 300 (e.g., the tuning element 300') are repaired before the bias voltage bias2 is applied again.

So far, the manufacturing process of an electronic device 20 provided in this embodiment is completed. It is worth noting that although the manufacturing process of the electronic device 20 provided in this embodiment is described by taking the above process as an example, the manufacturing process of the electronic device 20 provided in the disclosure is not limited to what is described above; some steps in the above manufacturing process may be deleted as required, or additional steps may be added to the manufacturing process. In addition, the order of the above steps may be adjusted according to actual demands.

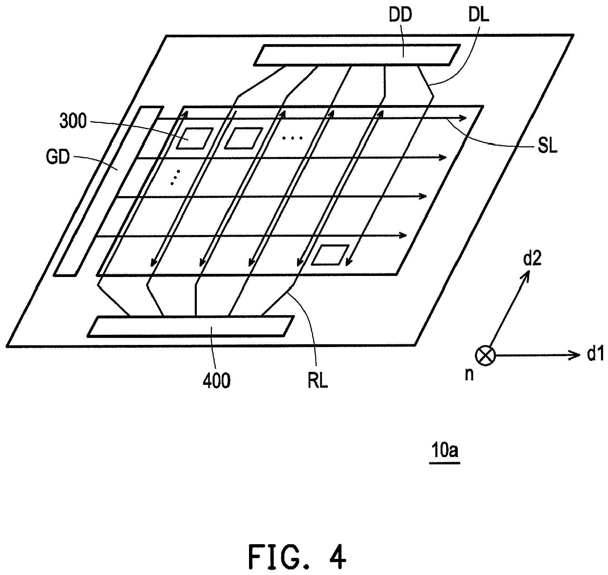

FIG. 4 is a schematic top view of FIG. IE according to a second embodiment of the disclosure. It should be mentioned that the reference numbers and some content provided in the embodiment shown in FIG. 3 may be applied in the embodiment shown in FIG. 4, where the same or similar reference numbers serve to denote the same or similar elements, and the description of the same technical content is omitted.

With reference to FIG. 4, one of the differences between the method of analyzing the variations of the electrical properties of the tuning elements 300 in the electronic device 10a provided in this embodiment and the method provided in the embodiment shown in FIG. 3 lies in that the testing device 500a is not applied to irradiate the tuning elements 300 in this embodiment. Specifically, the tuning elements 300 provided in this embodiment are operated in the reverse bias mode through the corresponding scan signals and data signals and transmit the resultant electrical signals to the read lines RL. The read lines RL may transmit the electrical signals coming from the tuning elements 300 to the processing chip 400, for instance, so that the processing chip 400 may analyze the tuning elements 300 according to the electrical signals and determine whether the tuning elements 300 are defective. According to this embodiment, after the processing chip 400 is applied to analyze the tuning elements 300, note that the read lines RL configured to couple the processing chip 400 to the tuning elements 300 may be cut off, so as to reduce the possibility that electrostatic charges may intrude into a region where the tuning elements 300 are disposed through the read lines RL, thereby achieving electrostatic discharge protection (ESD).

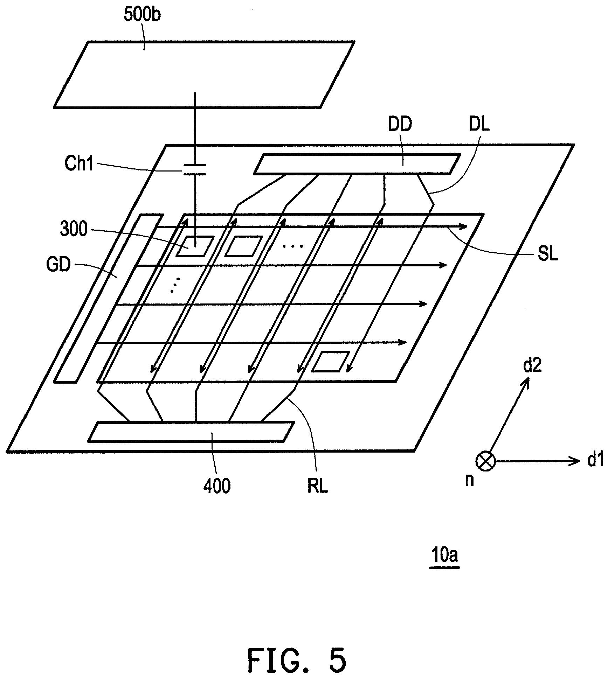

FIG. 5 is a schematic top view of FIG. IE according to a third embodiment of the disclosure. It should be mentioned that the reference numbers and some content provided in the embodiment shown in FIG. 3 may be applied in the embodiment shown in FIG. 5, where the same or similar reference numbers serve to denote the same or similar elements, and the description of the same technical content is omitted.

With reference to FIG. 5, one of the differences between the method of analyzing the variations of the electrical properties of the tuning elements 300 in the electronic device 10a provided in this embodiment and the method provided in the embodiment shown in FIG. 3 lies in that a testing device 500b is applied to analyze the variations of the electrical properties of the tuning elements 300 in this embodiment. Specifically, the testing device 500b provided in this embodiment includes a high-pressure capacitor Ch1, and the high-pressure capacitor Ch1 is coupled to the tuning elements 300. The high-pressure capacitor Ch1 may be, for instance, configured to store a high voltage coming from a voltage power source (not shown) in the testing device 500b, so as to provide a reference voltage. The tuning elements 300 which are operated in the reverse bias mode may then transmit the resultant electrical signals to the read lines RL. The read lines RL may transmit the electrical signals coming from the tuning elements 300 (the voltage difference between the tuning elements 300 and the high-pressure capacitor Ch1) to the processing chip 400, for instance, so that the processing chip 400 may analyze the tuning elements 300 according to the electrical signals and determines whether the tuning elements 300 are defective.

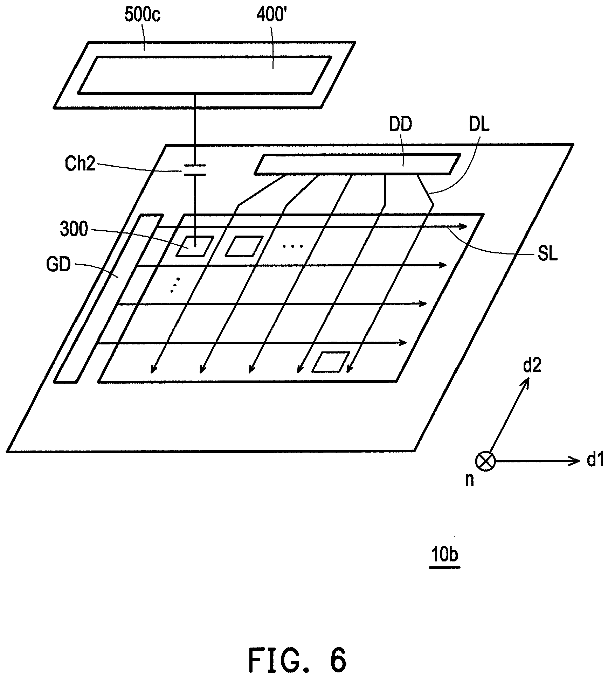

FIG. 6 is a schematic top view of FIG. IE according to a fourth embodiment of the disclosure. It should be mentioned that the reference numbers and some content provided in the embodiment shown in FIG. 3 may be applied in the embodiment shown in FIG. 6, where the same or similar reference numbers serve to denote the same or similar elements, and the description of the same technical content is omitted.

With reference to FIG. 6, which illustrates an analysis performed on the variations of the electrical properties of the tuning elements 300 of an electronic device 10b according to an embodiment of the disclosure, the electronic device 10b includes the scan lines SL, the data lines DL, the gate driver GD, the data driver DD, and the tuning elements 300. In this embodiment, a testing device 500c is applied to receive the electrical signals coming from the tuning elements 300. In detail, the testing device 500c provided in this embodiment includes a high-pressure capacitor Ch2, and the high-pressure capacitor Ch2 is coupled to the tuning elements 300. For instance, the high-pressure capacitor Ch2 may be configured to store the electrical signals coming from the tuning elements 300 which are operated in the reverse bias mode and may transmit the electrical signals to a processing chip 400' coupled to the high-pressure capacitor Ch2. The processing chip 400' may analyze the tuning elements 300 according to the electrical signals and determine whether the tuning elements 300 are defective. In addition, the manufacturing process of the electronic device 10b may be simplified by placing the processing chip 400' in the testing device 500c.

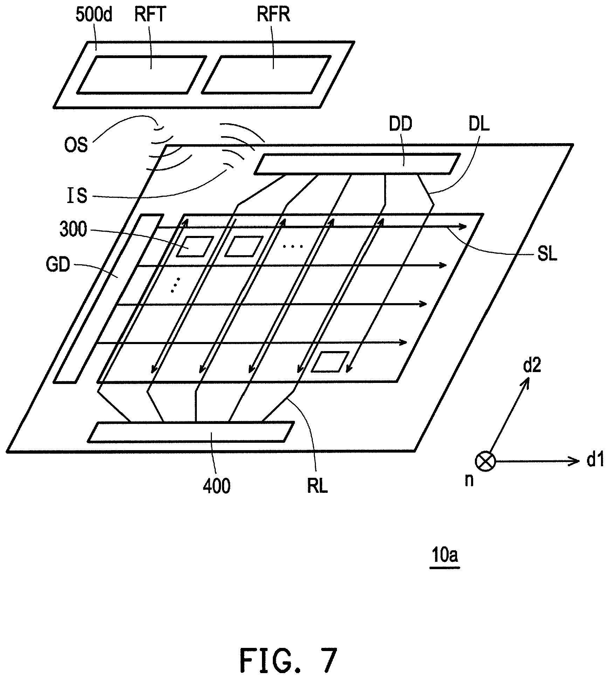

FIG. 7 is a schematic top view of FIG. IE according to a fifth embodiment of the disclosure. It should be mentioned that the reference numbers and some content provided in the embodiment shown in FIG. 3 may be applied in the embodiment shown in FIG. 7, where the same or similar reference numbers serve to denote the same or similar elements, and the description of the same technical content is omitted.

With reference to FIG. 7, one of the differences between the method of analyzing the variations of the electrical properties of the tuning elements 300 in the electronic device 10a provided in this embodiment and the method provided in the embodiment shown in FIG. 3 lies in that a testing device 500d is applied to transmit a radio-frequency signal, so as to analyze the variations of the electrical properties of the tuning elements 300 in this embodiment. Particularly, the testing device 500d provided in this embodiment includes a radio-frequency transmitter RFT and a radio-frequency receiver RFR. The radio-frequency transmitter RFT may, for instance, receive an encoded signal from an encoder (not shown) to generate a radio-frequency output signal and transmit the radio-frequency output signal to the tuning elements 300. After the tuning elements 300 receive the radio-frequency output signal OS, the tuning elements 300 feed back a radio-frequency input signal IS into the radio-frequency receiver RFR, and the radio-frequency receiver RFR may, for instance, transmit the radio-frequency input signal IS to a processor (not shown) for decoding. In addition, the tuning elements 300 which are operated in the reverse bias mode may transmit the resultant electrical signals to the read lines RL after receiving the radio-frequency output signal OS. The read lines RL may transmit the electrical signals coming from the tuning elements 300 to the processing chip 400, for instance. Therefore, the processing chip 400 analyzes the tuning elements 300 according to the electrical signals and determines whether the tuning elements 300 are defective, and/or a processor (not shown) may analyze the tuning elements 300 according to the radio-frequency output signal received by the radio-frequency transmitter RFT and determine whether the tuning elements 300 are defective.

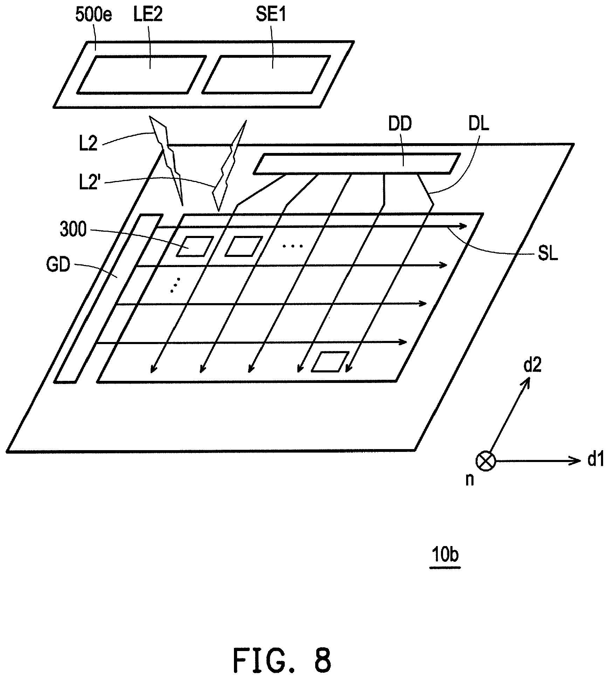

FIG. 8 is a schematic top view of FIG. IE according to a sixth embodiment of the disclosure. It should be mentioned that the reference numbers and some content provided in the embodiment shown in FIG. 3 may be applied in the embodiment shown in FIG. 8, where the same or similar reference numbers serve to denote the same or similar elements, and the description of the same technical content is omitted.

FIG. 8 illustrates an analysis performed on the variations of the optical properties of the tuning elements 300 of the electronic device 10b according to an embodiment of the disclosure, and the electronic device 10b includes the scan lines SL, the data lines DL, the gate driver GD, the data driver DD, and the tuning elements 300. In this embodiment, a testing device 500e is applied to receive the optical signals coming from the tuning elements 300. Specifically, in this embodiment, a forward bias voltage is applied to the tuning elements 300, so that the variation of the optical property of each of the tuning elements 300 may be individually tested. For instance, the testing device 500e includes a light emitting element LE2, a photosensitive element SE1, and a processing chip (not shown). The light emitting element LE2 is configured to irradiate the tuning elements 300 with a light beam L2. When the light beam L2 is applied to irradiate the tuning elements 300, the tuning elements 300 reflect the light beam L2, and the reflected light beam L2' is sensed by the photosensitive element SE1. Here, the energy of the light beam L2 is attenuated after the light beam L2 is reflected by the tuning elements 300, and thus a wavelength of the light beam L2' sensed by the photosensitive element SE1 is greater than a wavelength of the light beam L2. Therefore, by detecting a variation of an optical property (e.g., the variation of the wavelength) of the light beam L2' reflected by the tuning elements 300, the processing chip (not shown) may analyze the tuning elements 300 and determine whether the tuning elements 300 are defective according to the variation of the optical property. In some embodiments, the variation of the optical property may include a variation of a wavelength, a variation of an amplitude, a variation of light intensity, or other variations of optical properties, which should not be construed as a limitation in the disclosure.

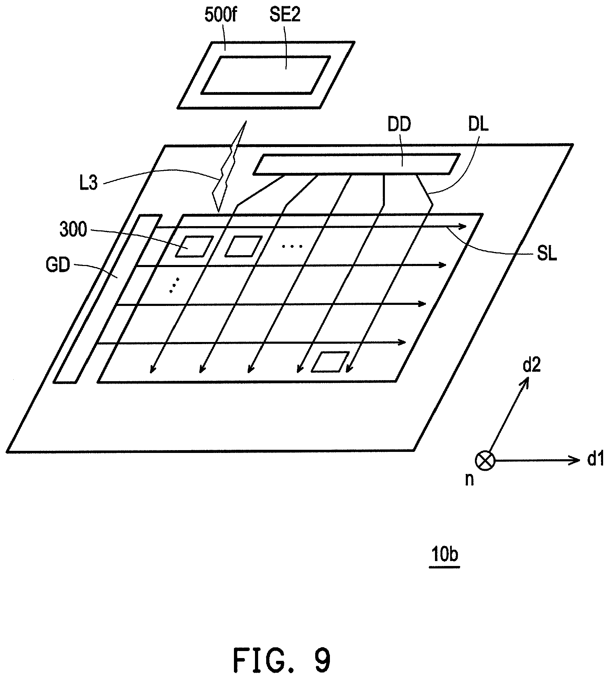

FIG. 9 is a schematic top view of FIG. IE according to a seventh embodiment of the disclosure. It should be mentioned that the reference numbers and some content provided in the embodiment shown in FIG. 8 may be applied in the embodiment shown in FIG. 9, where the same or similar reference numbers serve to denote the same or similar elements, and the description of the same technical content is omitted.

With reference to FIG. 9, one of the differences between the method of analyzing the variations of the electrical properties of the tuning elements 300 in the electronic device 10b provided in this embodiment and the method provided in the embodiment shown in FIG. 8 lies in that a testing device 500f is applied to receive optical signals coming from the tuning elements 300 in this embodiment. Specifically, in this embodiment, a forward bias voltage is applied to the tuning elements 300, so that the variation of the optical property of each of the tuning elements 300 may be individually tested. For instance, the testing device 500f includes a photosensitive element SE2 and a processing chip (not shown). The photosensitive element SE2 is configured to sense a light beam L3 emitted by the tuning elements 300 which are operated in a forward bias mode. Therefore, by detecting a variation of an optical property of the light beam L3 emitted by the tuning elements 300, the processing chip (not shown) may analyze the tuning elements 300 and determine whether the tuning elements 300 are defective according to the variation of the optical property. When the light beam L3 emitted by the tuning elements 300 is an infrared light beam, it should be mentioned that the testing device 500f may include a thermal imager, which should not be construed as a limitation in the disclosure.

To sum up, a testing method of an electronic device is provided in one or more embodiments of the disclosure. According to one or more embodiments of the disclosure, the reverse bias voltage or the forward bias voltage is applied to the tuning elements, so that the variation of the electrical property or the variation of the optical property of each of the tuning elements may be tested. After the variations of the electrical properties or the variations of the optical properties of the tuning elements are analyzed, whether one or more of the tuning elements are defective may be determined, and thereby the defective one or more of the tuning elements may be repaired in time. In addition, after the tuning elements are packaged by the package layer, the reverse bias voltage or the forward bias voltage may be applied again to the tuning elements, so that the variation of the electrical property or the variation of the optical property of each of the tuning elements may be individually tested again. After that, the variation of the electrical property of the individual tuning element is converted to the electrical data (such as the variability of the tuning element) and stored, so as to allow subsequent compensation to be performed according to the stored electrical data.

## Claims

1. A manufacturing method of an electronic device (10a, 20), comprising:
providing a tuning element substrate having a circuit layer (200) disposed on a substrate (100) and a plurality of tuning elements (300) disposed on the circuit layer (200);
applying a first reverse bias (bias1) voltage to the tuning elements (300), so as to test a first variation of an electrical property of each of the tuning elements (300); and
analyzing the first variation of the electrical property of each of the tuning elements (300).

2. The manufacturing method according to claim 1, wherein after the first variation of the electrical property of each of the tuning elements (300) is analyzed and one or more of the tuning elements (300') are determined to be defective through the test, the defective one or more of the tuning elements (300') are repaired.

3. The manufacturing method according to claim 1, further comprising: placing a package layer (600) on the tuning elements (300).

4. The manufacturing method according to claim 1, further comprising: providing a processing chip (400, 700) electrically connected to the tuning elements (300).

5. The manufacturing method according to claim 4, further comprising: applying a second reverse bias (bias2) voltage to the tuning elements (300), so as to test a second variation of the electrical property of each of the tuning elements (300).

6. The manufacturing method according to claim 5, wherein the processing chip (400, 700) is configured to receive the second variation, convert the second variation to electrical data, and store the electrical data.

7. The manufacturing method according to claim 5, wherein after the first variation of the electrical property of each of the tuning elements (300) is analyzed and one or more of the tuning elements (300') are determined to be defective through the test, the defective one or more of the tuning elements (300') are repaired before the second reverse bias voltage (bias2) is applied.

8. The manufacturing method according to claim 1, wherein the step of applying the first reverse bias voltage (bias1) to the tuning elements (300) comprises providing a signal (LI, OS) to the tuning elements (300) by a testing device (500, 500a, 500b, 500d).

9. A manufacturing method of an electronic device (10b, 20), comprising:
providing a tuning element substrate having a circuit layer (200) disposed on a substrate (100) and a plurality of tuning elements (300) disposed on the circuit layer (200);
applying a first forward bias voltage (bias1) to the tuning elements (300), so as to test a first variation of an optical property of each of the tuning elements (300); and
analyzing the first variation of the optical property of each of the tuning elements (300).

10. The manufacturing method according to claim 9, wherein after the first variation of the optical property of each of the tuning elements (300) is analyzed and one or more of the tuning elements (300') are determined to be defective through the test, the defective one or more of the tuning elements (300') are repaired.

11. The manufacturing method according to claim 9, further comprising: placing a package layer (600) on the tuning elements (300).

12. The manufacturing method according to claim 9, further comprising: applying a second forward bias voltage (bias2) to the tuning elements (300), so as to test a second variation of the optical property of each of the tuning elements (300).

13. The manufacturing method according to claim 12, further comprising: providing a processing chip (400', 700), wherein the processing chip (400', 700) is configured to receive the second variation, convert the second variation to electrical data, and store the electrical data.

14. The manufacturing method according to claim 12, wherein after the first variation of the optical property of each of the tuning elements (300) is analyzed and one or more of the tuning elements (300') are determined to be defective through the test, the defective one or more of the tuning elements (300') are repaired before the second forward bias voltage (bias2) is applied.

15. The manufacturing method according to claim 9, wherein the step of applying the first forward bias voltage (bias1) to the tuning elements (300) comprises receiving a signal (L2, L3') from the tuning elements (300') by a testing device (500, 500c, 500e, 500f).
